(19) Europäisches Patentamt
European Patent Office
Office européen des brevets

(11) Veröffentlichungsnummer: **0 174 647**
**A2**

(12) # EUROPÄISCHE PATENTANMELDUNG

(21) Anmeldenummer: 85111478.5

(22) Anmeldetag: 11.09.85

(51) Int. Cl.[4]: C 08 L 83/07
C 08 L 83/08, C 08 J 3/28

(30) Priorität: 13.09.84 DE 3433654

(43) Veröffentlichungstag der Anmeldung: 19.03.86 Patentblatt 86/12

(84) Benannte Vertragsstaaten: BE DE FR GB IT NL

(71) Anmelder: WACKER-CHEMIE GMBH
Prinzregentenstrasse 22
D-8000 München 22(DE)

(72) Erfinder: Preiner, Gerhard, Dr. Dipl.-Chem.
Karl-Gross-Strasse 17
D-8263 Burghausen(DE)

(72) Erfinder: Matejcek, Klaus, Dr. Dipl.-Chem.
Hansjakobstrasse 117 a
D-8000 München 82(DE)

(54) **Durch Ultraviolett-Licht vernetzbare Organopolysiloxan-Massen und Verfahren zum Einbetten von elektronischen Bauteilen.**

(57) Massen, die als wesentliche Bestandteile

(A) Organopolysiloxan mit Einheiten der Formel
$HR^1C{=}CR^2COOR^3SiR_2O_{1/2}$

worin R ein einwertiger, gegebenenfalls halogenierter Kohlenwasserstoffrest, $R^1$ Wasserstoff oder ein gegebenenfalls halogenierter Phenylrest, $R^2$ Wasserstoff oder ein Alkylrest mit 1 bis 4 C-Atomen je Rest und $R^3$ ein zweiwertiger Kohlenwasserstoffrest ist, der halogeniert sein kann, wobei 2 solcher Siloxaneinheiten je Molekül vorliegen, während die restlichen Siloxaneinheiten zu mindestens 80% ihrer Anzahl solcher der Formel

$R_2SiO$

sind, mit einer durchschnittlichen Viskosität von 20 bis 5000 mPa.s bei 25°C

(B) durch Einheiten der Formel
$R_3SiO_{1/2}$

(a = 0 oder 1), während die restlichen Siloxaneinheiten, abgesehen von den Triorganosiloxaneinheiten zu mindestens 99 Molprozent aus Einheiten der Formel

$R_2SiO$

bestehen, mit einer durchschnittlichen Viskosität von 50 bis 2000 mPa.s bei 25°C und

(C) Photosensibilisator enthalten, wobei Si-gebundene Hydroxylgruppen, die sich in Einheiten der Formel

$R_2SiO$

befinden, höchstens in Mengen von 0, 2 Hydroxylgruppen je Gruppierung der Formel

$HR^1C{=}CR^2COOR^3-$

vorliegen
und in diesen Massen insgesamt höchstens 0, 02 Gewichtsprozent, bezogen auf das Gesamtgewicht der Bestandteile (A), (B) und (C), organische Titan- oder organische Zinnverbindungen vorliegen, sind durch Ultraviolett-Licht vernetzbar und eignen sich ausgezeichnet zum Einbetten von elektronischen Bauteilen.

./...

EP 0 174 647 A2

Croydon Printing Company Ltd.

endblockiertes Organopolysiloxan mit 0.05 bis 5 Molprozent Einheiten der Formel

$$HSR^3R_aSiO_{\frac{3-a}{2}}$$

Wacker-Chemie GmbH

München, den 09.08.1984
PAT/Dr.Ru/hu

Wa 8404-S

# Durch Ultraviolett-Licht vernetzbare Organopolysiloxan-Massen und Verfahren zum Einbetten von elektronischen Bauteilen.

Aus US 4 290 869 (ausgegeben 22. Sept. 1982, R. Pigeon, Rhône-Poulenc Industries) sind bereits photopolymerisierbare Organopolysiloxan-Massen mit SiC-gebundenen Acryloxyalkyl- oder Methacryloxyalkylgruppen sowie Mercaptoalkylgruppen bekannt. In diesen bekannten Massen liegen Silane neben Organopolysiloxanen vor, schon weil bei der Herstellung der zu ihrer Bereitung verwendeten Bestandteile höchstens 45 Gewichtsprozent der theoretischen Menge von Alkanol freigesetzt werden darf. Gemäß der vorstehend genannten Druckschrift, Spalte 8, Zeilen 36 bis 38, haben derartige Zusammensetzungen in verschlossenen und undurchsichtigen Behältern eine Lagerbeständigkeit von etwa 48 Stunden. Daß die Massen gemäß US 4 290 869 zum Einbetten von elektronischen Bauteilen geeignet seien, wird in dieser Druckschrift nicht behauptet.

Es bestand die Aufgabe, Massen aus verhältnismäßig leicht zugänglichen Bestandteilen bereitzustellen, welche in verschlossenen Behältern, unter Ausschluß von Licht, insbesondere Ultraviolett-Licht, mindestens 6 Monate gelagert werden können, vor Beginn ihrer Vernetzung genügend niedrig viskos sind, um auch in verhältnismäßig enge Zwischenräume eindringen zu können, nicht den beim Endverbraucher für Zweikomponenten-Systeme erforderlichen Dosieraufwand benötigen, in den zu ihrer endgültigen Verarbeitung benutzten Vorrichtungen bei deren Stillstand nicht vernetzen können, was Reinigungsaufwand für diese Vorrichtungen vermeidet, keinen unangenehmen Geruch verbreiten, unter der Einwirkung von Ultraviolett-Licht bei Raumtemperatur bzw. bei Temperaturen, die 100°C nicht übersteigen, rasch vernetzen, wobei die Vernetzung durch Luft-Sauerstoff in für das Einbetten von elektronischen Bauteilen nicht vertretbarem Ausmaß nicht beeinträchtigt wird, und die bei ihrer Vernetzung Produkte ergeben, die durchsichtig, weich und von gelartiger Konsistenz sowie "selbstheilend" sind, d. h. wenn sie z. B. durchgeschnitten worden sind und die durch den Schnitt von einander getrennten Teile genügend nahe bei einander sind, wieder zusammenfließen, wobei die Vernetzungsprodukte trotzdem von den Unterlagen, auf denen diese Produkte erzeugt wurden nicht abfließen. Diese Aufgabe wird durch die Erfindung gelöst, so daß sich die erfindungsgemäßen Massen ausgezeichnet zum Einbetten von elektronischen Bauteilen eignen.

Gegenstand der Erfindung sind durch Ultraviolett-Licht vernetzbare Organopolysiloxan-Massen, die sowohl Einheiten der Formel

$$HR^1C{=}CR^2COOR^3SiR_2O_{1/2} ,$$

worin R ein einwertiger, gegebenenfalls halogenierter Kohlenwasserstoffrest, $R^1$ Wasserstoff oder ein gegebenenfalls halogenierter Phenylrest, $R^2$ Wasserstoff oder ein Alkylrest mit 1 bis 4 C-Atomen je Rest und $R^3$ ein zweiwertiger

Kohlenwasserstoffrest ist, der halogeniert sein kann, als auch Einheiten der Formel

$$HSR^3R_aSiO_{\frac{3-a}{2}} ,$$

worin R und $R^3$ jeweils die oben dafür angegebene Bedeutung haben und a 0 oder 1 ist, enthalten, dadurch gekennzeichnet, daß sie als wesentliche Bestandteile

(A) Organopolysiloxan mit Einheiten der Formel

$$HR^1C{=}CR^2COOR^3SiR_2O_{1/2} ,$$

worin R, $R^1$, $R^2$ und $R^3$ jeweils die oben dafür angegebene Bedeutung haben, wobei 2 solcher Siloxaneinheiten je Molekül von Bestandteil (A) vorliegen, während die restlichen Siloxaneinheiten in Bestandteil (A) zu mindestens 80 % ihrer Anzahl aus Einheiten der Formel

$$R_2SiO$$

bestehen, worin R die oben dafür angegebene Bedeutung hat, und wobei Bestandteil (A) eine durchschnittliche Viskosität von 20 bis 5000 mPa.s bei 25°C hat,

(B) durch Einheiten der Formel $R_3SiO_{1/2}$, wobei R die oben dafür angegebene Bedeutung hat, endblockiertes Organopolysiloxan mit 0,05 bis 5 Molprozent Einheiten der Formel

$$HSR^3R_aSiO_{\frac{3-a}{2}} ,$$

worin R, $R^3$ und a jeweils die oben dafür angegebene Bedeutung haben, während die restlichen Siloxaneinheiten, abgesehen von den Triorganosiloxygruppen, zu mindestens 99 Molprozent aus Einheiten der Formel

$$R_2SiO,$$

worin R die oben dafür angegeben Bedeutung hat, bestehen, und wobei Bestandteil (B) eine durchschnittliche Viskosität von 50 bis 2000 mPa.s bei 25°C hat, und

(C) Photosensibilisator

enthalten, wobei Si-gebundene Hydroxylgruppen, die sich in Einheiten der Formel

$$R_2SiO$$

befinden, höchstens in Mengen von 0,2 Hydroxylgruppen je Gruppierung der Formel

$$HR^1C{=}CR^2COOR^3-$$

vorliegen, und in diesen Massen insgesamt höchstens 0,02 Gewichtsprozent, bezogen auf das Gesamtgewicht der Bestandteile (A), (B) und (C),organische Titan- oder organische Zinnverbindungen vorliegen.

Die erfindungsgemäßen Massen unterscheiden sich also von den Massen gemäß US 4 290 869 z. B. dadurch, daß sie

die in dieser Druckschrift nicht erwähnten Einheiten der Formel

$$R_3SiO_{1/2}$$

enthalten,
keine oder viel weniger Si-gebundene Hydroxylgruppen in Einheiten der Formel

$$R_2SiO$$

enthalten und
keine oder viel weniger organische Titan- oder Zinnverbindungen enthalten. Es ist überraschend, daß die erfindungsgemäßen Massen trotz dieser Unterschiede rasch vernetzen, wenn sie Ultraviolett-Licht ausgesetzt werden.

Beispiele für Kohlenwasserstoffreste R sind Alkylreste mit 1 bis 18 Kohlenstoffatomen je Rest, wie der Methyl-, Ethyl-, n-Propyl-, Isopropyl-, n-Butyl- und sec.-Butylrest sowie Octadecylreste; Cycloalkylreste mit 5 bis 8 Kohlenstoffatomen je Rest, wie der Cyclohexyl- und Cycloheptylrest sowie Methylcyclohexylreste; Reste mit aliphatischen Kohlenstoff-Kohlenstoff-Doppelbindungen und 2 bis 18 Kohlenstoffatomen je Rest, wobei diese Reste aus Kohlenstoff- und Wasserstoffatomen als einzigen Atomen aufgebaut sind, wie der Vinyl- und Allylrest; Arylreste mit 6 bis 12 Kohlenstoffatomen je Rest, wie der Phenylrest und Xenylreste; Alkarylreste mit 7 bis 18 Kohlenstoffatomen je Rest, wie Tolylreste; und Aralkylreste mit 7 bis 18 Kohlenstoffatomen je Rest, wie der Benzyl- und beta-Phenylethylrest.

Beispiele für halogenierte Kohlenwasserstoffreste R sind der 3-Chlorpropyl- und 3,3,3-Trifluorpropylrest sowie o-, p- und n-Chlorphenylreste.

Vorzugsweise sind schon wegen der leichten Zugänglichkeit mindestens 95 % der Anzahl der Reste R Methylreste.

Vorzugsweise ist $R^1$ Wasserstoff. Beispiele für halogenierte Phenylreste sind o-, m- und p-Chlorphenylreste.

Vorzugsweise ist auch $R^2$ Wasserstoff. $R^2$ kann aber auch z. B. eine Methylgruppe sein.

Vorzugsweise ist $R^3$ ein Rest der Formel $-(CH_2)_p-$ ,

worin p eine ganze Zahl im Wert von 1 bis 6, insbesondere 3 ist. $R^3$ kann aber auch z. B. ein verzweigter Alkylenrest, wie der Rest der Formel

$$-CH_2C(CH_3)_2CH_2-,$$

Arylenreste, wie Phenylenreste, Alkarylenrest, wie Reste der Formel

$$-(CH_2)_2C_6H_4- ,$$

oder Aralkylenrest, wie Toluylenreste sein.

Beispiele für halogenierte Reste $R^3$ sind o-, p- und m-Chlorphenylenreste.

Die Siloxaneinheiten, die zusätzlich zu den Einheiten der Formel

$HR^1C{=}CR^2COOR^3SiR_2O_{1/2}$ und $R_2SiO$

in Bestandteil (A) gegebenenfalls vorliegen können, sind vorzugsweise solche der Formel $RSiO_{3/2}$, wobei R die oben dafür angegebene Bedeutung hat, oder $SiO_{4/2}$. Sie können in Mengen von insgesamt bis zu 20 % der Anzahl der anderen Siloxaneinheiten als Einheiten der Formel

$$HR^1C{=}CR^2COOR^3SiR_2SiO_{1/2}$$

in Bestandteil (A) vorliegen. Vorzugsweise liegen sie jedoch nur in Mengen von insgesamt höchstens 5 % der Anzahl aller Siloxaneinheiten in Bestandteil (A) vor.

Vorzugsweise hat Bestandteil (A) eine Viskosität von 100 bis 2000 mPa.s bei 25°C.

Verfahren zur Herstellung von Bestandteil (A) ohne Mitverwendung von organischen Titan- oder Zinnverbindungen, von denen Bestandteil (A) erst zumindest weitgehend befreit werden müsste, um zur Bereitung der erfindungsgemäßen Massen geeignet zu sein, sind bekannt. Hierzu wird z.B. auf DE-OS 28 29 367 (offengelegt 8. Februar 1979, Bausch & Lomb) und DE-OS 32 22 839 (offengelegt 22. Dezember 1983, Wacker-Chemie GmbH) verwiesen.

Vorzugsweise enthält Bestandteil (B) 0,5 bis 1 Molprozent Einheiten der Formel

$$HSR^3R_aSiO_{\frac{3-a}{2}} .$$

Weiterhin ist es bevorzugt, daß Bestandteil (B) eine Viskosität von 100 bis 1000 mPa.s bei 25°C hat.

Die Siloxaneinheiten, die zusätzlich zu den Einheiten der Formel

$$HSR^3R_aSiO_{\frac{3-a}{2}} \quad \text{und} \quad R_2SiO$$

in Bestandteil (B) vorliegen können, sind vorzugsweise ebenfalls solche der Formel $RSiO_{3/2}$, wobei R die oben dafür zugegebene Bedeutung hat, oder $SiO_{4/2}$.

Die Einheiten der Formel $R_3SiO_{1/2}$ sind vorzugsweise $(CH_3)_3SiO_{1/2}$-Einheiten.

Verfahren zur Herstellung von Bestandteil (B) ohne Mitverwendung von organischen Titan- oder Zinnverbindungen, von denen Bestandteil (B) erst zumindest weitgehend befreit werden müßte, um zur Bereitung der erfindungsgemäßen Massen geeignet zu sein, sind bekannt. Hierzu wird z. B. auf US 4 046 795 (ausgegeben 6. September 1977, E. R. Martin, SWS Silicones Corporation) und GB 2 076 842 B (Wacker-Chemie GmbH, P. Huber, veröffentlicht 7. Dezember 1981) verwiesen.

Vorzugsweise enthalten die erfindungsgemäßen Massen Bestandteil (A) und (B) in solchen Mengenverhältnissen, daß 0,5 bis 10 Einheiten der Formel

$$HSR^3R_aSiO_{\frac{3-a}{2}}$$

je Einheit der Formel

$$HR^1C{=}CR^2COOR^3SiR_2O_{1/2}$$

vorliegen.

Als Photosensibilisatoren (C) können beliebige handelsübliche Photosensibilisatoren verwendet werden. Bevorzugt sind Photosensibilisatoren, die in den Bestandteilen (A) und (B) löslich sind, wie 2-Hydroxy-2-methyl-1-phenylpropan-1-on und 2,4-Bis-(trimethylsiloxy)-benzophenon. Weitere Beispiele für Photosensibilisatoren (C) sind Benzophenon und substituierte Benzophenone, Benzoin und substituierte Benzoine, Acetophenon und substituierte Acetophenone, Benzil und substituierte Benzile. Im einzelnen seien aufgeführt: Acetophenon, 2-Ethoxy-2-methylacetophenon, Mesityloxyd, Propiophenon, Benzophenon, Xanthon, Thioxanthon, Fluorenon, Benzaldehyd, Fluoren, Anthrachinon, Carbazol, 3-Methylacetophenon, 4-Methylacetophenon, 3-Bromacetophenon, 4-Methylbenzophenon, 4-Chlorbenzophenon, 4,4-Dimethoxybenzophenon, 4-Chlor-4'-benzylbenzophenon, 3-Chlorxanthon, 3,9-Dichlorxanthon, 3-Chlor-8-nonylxanthon, Chloranthrachinone, Michler's Keton, Zimtsäure, Benzoinmethylether, Anthrachinon-1,5-disulfonsäuredinatriumsalz, 2-Naphthalinsulfonylchlorid,

Benzil, Benzilketale und Hydroxybenzophenone.

Bevorzugte Photosensibilisatoren sind z. B. unter den Bezeichnungen "Darocur 1173", "Darocur 1116", "Darocur 953" bei der Firma Merck, Darmstadt, BRD erhältlich. (Bei der Bezeichnung "Darocur" dürfte es sich um ein registriertes Warenzeichen handeln).

Photosensibilisator-Mengen von 0,01 bis 5 Gewichtsprozent, bezogen auf das Gesamtgewicht der Bestandteile (A) und (B), sind ausreichend.

Zusätzlich zu den wesentlichen Bestandteilen (A), (B) und (C) können die erfindungsgemäßen Massen gegebenenfalls weitere Stoffe enthalten. Beispiele für derartige weitere Stoffe sind insbesondere Mittel zur Verbesserung der Haftung der vernetzten Organopolysiloxane auf den Unterlagen, auf denen sie vernetzt wurden, wie Butandioldiacrylsäureester und gamma-Glycidoxypropyltriacetoxysilan.

Als Ultraviolett-Licht ist solches mit Wellenlängen im Bereich von 200 bis 400 nm (Nanometer) bevorzugt.

Die Vernetzung der erfindungsgemäßen Massen wird der Einfachheit halber vorzugsweise beim Druck der umgebenden Atmosphäre, also bei 1020 hPa (abs.) oder etwa 1020 hPa (abs.) durchgeführt. Falls erwünscht, können aber auch höhere oder niedrigere Drücke angewendet werden.

Die Vernetzung erfolgt innerhalb von 0,5 bis 20 Sekunden, wenn die erfindungsgemäßen Massen Ultraviolett-Licht ausgesetzt werden.

Gegenstand der Erfindung ist weiterhin ein Verfahren zum Einbetten von elektronischen Bauteilen, dadurch gekennzeichnet, daß Massen aus den oben näher beschriebenen Bestandteilen (A), (B) und (C), nachdem in ihnen elektronische Bauteile eingebettet wurden, durch Ultraviolett-Licht vernetzt werden.

Nach dem erfindungsgemäßen Verfahren können beliebige elektronische Bauteile eingebettet werden, die auch bisher in Organopolysiloxane eingebettet werden konnten. Beispiele für derartige elektronische Bauteile sind Hybridschaltkreise z. B. für elektronische Zündungen, Module, photovoltaische Solargeneratoren und andere Halbleiteranordnungen.

In den folgenden Beispielen beziehen sich alle Angaben von Teilen auf das Gewicht, soweit nichts anderes angegeben ist.

<u>Beispiel 1</u>

10 Teile eines Organopolysiloxans der Formel

$$H_2C{=}CHCOO(CH_2)_3(CH_3)_2SiO\left[Si(CH_3)_2O\right]_bSi(CH_3)_2(CH_2)_3OOCHC{=}CH_2,$$

worin b durchschnittlich 200 ist, das eine Viskosität von 600 mPa.s bei 25°C hat, werden als Bestandteil (A) mit 30 Teilen eines durch Trimethylsiloxygruppen endblockierten Organopolysiloxans aus 0,77 Molprozent Einheiten der Formel

$$HS(CH_2)_3SiO_{3/2}$$

und 99,23 Molprozent Dimethylsiloxaneinheiten mit einer Viskosität von 210 mPa.s bei 25°C als Bestandteil (B), so daß das Verhältnis von Mercaptopropylgruppen zu Acryloxypropylgruppen 2,3 : 1 beträgt, und
0,8 Teilen 2-Hydroxy-2-methyl-1-phenylpropan-1-on als Bestandteil (C) vermischt.

Die so erhaltene Mischung ist auch nach 6-monatiger Lagerung bei Raumtemperatur in einem verschlossenen Behälter unter Lichtausschluß hinsichtlich ihrer Viskosität und Transparenz sowie aller übrigen Eigenschaften völlig unverändert. Eine 5 mm tiefe Polymethacrylglasschale, in der sich Module befinden, wird mit dieser Masse gefüllt und diese Masse dort mit einer Quecksilber-Mitteldruck-Ultraviolett-Lampe mit einer Leistung von 80 Watt/cm Leuchtlänge und einem Maximum der Leistung bei 366 nm in einem Abstand von 10 cm belichtet. Nach 5 Sekunden ist die Flüssigkeit zu einem völlig transparenten, nicht mehr fließfähigem Produkt von gelartiger Konsistenz vernetzt. Die Masse wurde durch die Wärmeabstrahlung der Lampe lediglich auf 30°C erwärmt.

Beispiel 2

Die in Beispiel 1 beschriebene Arbeitsweise wird wiederholt mit der Abänderung, daß 20 Teile Bestandteil (B) anstelle der 30 Teile Bestandteil (B) verwendet werden, so daß das Verhältnis von Mercaptopropylgruppen zu Acryloxypropylgruppen 1,54 : 1 beträgt, und 0,6 Teile Bestandteil (C) anstelle der 0,8 Teile Bestandteil (C) verwendet werden. Die Vernetzungszeit bei der Ultraviolett-Belichtung beträgt 5 Sekunden. Das vernetzte Produkt ist völlig transparent, nicht mehr fließfähig und von gelartiger Konsistenz. Es ist etwas härter und etwas weniger klebrig als das gemäß Beispiel 1 hergestellte vernetzte Produkt.

Beispiel 3

10 Teile des in Beispiel 1 näher beschriebenen Bestandteils (A) werden mit
15 Teilen des in Beispiel 1 näher beschriebenen Bestandteils (B) und
0,15 Teilen des Bestandteils (C) der in Beispiel 1 angegebenen Art
vermischt. In die so erhaltene Masse wird ein Hybridschaltkreis bis zu einer maximalen Schichtdicke von 3 mm eingebettet und, wie in Beispiel 1 beschrieben, belichtet. Die Vernetzungszeit beträgt 3 Sekunden. Das vernetzte Produkt ist glasklar, farblos, nicht mehr fließfähig und von gelartiger Konsistenz.Nach 4 Wochen Erwärmen des vernetzten Produktes auf 70°C ist keine Veränderung seiner Konsistenz festzustellen.

Die elektrischen Prüfwerte des vernetzten Produktes sind:

Spezifischer Durchgangswiderstand nach DIN 53 482 bei 2 mm Schichtdicke, Trockenmessung bei 23°C: $5{,}2 \cdot 10^{15}$ Ohm.cm
Durchschlagsfestigkeit nach DIN 53 481: 21 KV/mm
Dielektrizitätskonstante epsilon bei 23°C im Frequenzbereich von 50 Hz bis 5 MHz nach DIN 53 483: 2,9 bis 3,2
Verlustfaktor tg delta bei 23°C nach DIN 53 843:

| 50 Hz | 5 kHz | 5 MHz |
|---|---|---|
| $155 \cdot 10^{-4}$ | $20 \cdot 10^{-4}$ | $10 \cdot 10^{-4}$ |

Der in den Beispielen 1 bis 3 verwendete Bestandteil (A) wurde nach folgender Vorschrift hergestellt:

Eine Mischung aus 2130 g (28,78 Mol) eines in den endständigen Einheiten je eine Si-gebundene Hydroxylgruppe aufweisenden Dimethylpolysiloxans mit durchschnittlich 70 Siliciumatomen je Molekül, 147 g (0,13 Mol) des Organopolysiloxans der Formel

$$H_2C{=}CHCOO(CH_2)_3Si(CH_3)_2O\left[Si(CH_3)_2O\right]_9Si(CH_3)_2(CH_2)_3OOCHC{=}CH_2$$

und 69 g säurebehandeltem Montmorillonit wird 3 Stunden unter Rühren auf 100°C erwärmt. Anschließend wird vom Montmorillonit abfiltriert. Das Filtrat ist Bestandteil (A).

Der zur Herstellung von Bestandteil (A) verwendete säurebehandelte Montmorillonit ist im Handel erhältlich. Er ist aus Siliciumdioxyd, Aluminiumoxyd, Eisen (III)-Oxyd, Magnesiumoxyd, Natriumoxyd und Kaliumoxyd aufgebaut und hat folgende Kennzahlen:

Schüttgewicht 450 g/l
Rüttelgewicht 670 g/l
Spezifisches Gewicht 2,4 kg/l
Feuchtigkeitsgehalt (2h, 110°C): höchstens 7 Gewichtsprozent
Glühverlust (1000°C): höchstens 7 Gewichtsprozent
pH in 10 gewichtsprozentiger wäßriger Suspension: 2,9
97 Gewichtsprozent gehen durch ein Sieb mit einer lichten Maschenweite von 150 Micrometer.

Der in den Beispielen 1 bis 3 verwendete Bestandteil (B) wurde nach folgender Vorschrift hergestellt:

In einem 4-l-Dreihalskolben, der mit Rührer, Thermometer und Rückflußkühler ausgestattet wird, wird unter Rühren ein Gemisch aus

782 g (10,5 Mol) in den endständigen Einheiten je eine Si-gebundene Hydroxylgruppe aufweisenden Dimethylpolysiloxans mit 3,5 Gewichtsprozent Si-gebundenen Hydroxylgruppen

51,6 g (0,26 Mol) gamma-Mercaptopropyltrimethoxysilan

170 g Toluol

20 g (0,18 Mol) wasserfreien Calciumchlorids (zur Bindung von bei der Umsetzung gebildetem Wasser) und

3 g säurebehandelten Montmorillonits mit den oben angegebenen Kennzahlen

innerhalb 30 Minuten auf 70°C erwärmt, 2 Stunden bei 70°C gehalten und dann 2 Stunden auf 100°C erwärmt. Nach dem Abkühlen auf 80°C wird der Kolbeninhalt mit 1350 g (18,2 Mol) durch Trimethylsiloxygruppen endblockiertes Dimethylpolysiloxan mit einer Viskosität von 100 mPa.s bei 25°C, 70 g säurebehandelten Montmorillonits mit den oben angegebenen Kennzahlen und 20 g wasserfreiem Calciumchlorids vermischt und 3 Stunden auf 100°C erwärmt. Nach dem Abkühlen wird von festen Bestandteilen abfiltriert. Das Filtrat ist Bestandteil (B).

Patentansprüche:

1. Durch Ultraviolett-Licht vernetzbare Organopolysiloxanmassen, die sowohl Einheiten der Formel

$$HR^1C{=}CR^2COOR^3SiR_2O_{1/2} \quad ,$$

worin R ein einwertiger, gegebenenfalls halogenierter Kohlenwasserstoffrest, $R^1$ Wasserstoff oder ein gegebenenfalls halogenierter Phenylrest, $R^2$ Wasserstoff oder ein Alkylrest mit 1 bis 4 C-Atomen je Rest und $R^3$ ein zweiwertiger Kohlenwasserstoffrest ist, der halogeniert sein kann, als auch Einheiten der Formel

$$HSR^3R_aSiO_{\frac{3-a}{2}} \quad ,$$

worin R und $R^3$ jeweils die oben dafür angegebene Bedeutung haben und a 0 oder 1 ist, enthalten, dadurch gekennzeichnet, daß sie als wesentliche Bestandteile

(A) Organopolysiloxan mit Einheiten der Formel

$$HR^1C{=}CR^2COOR^3SiR_2O_{1/2} \quad ,$$

worin R, $R^1$, $R^2$ und $R^3$ jeweils die oben dafür angegebene Bedeutung haben, wobei 2 solcher Siloxaneinheiten je Molekül von Bestandteil (A) vorliegen, während die restlichen Siloxaneinheiten in Bestandteil (A) zu mindestens 80 % ihrer Anzahl aus Einheiten der Formel

$$R_2SiO$$

bestehen, worin R die oben dafür angegebene Bedeutung hat, und wobei Bestandteil (A) eine durchschnittliche Viskosität von 20 bis 5000 mPa.s bei 25°C hat,

(B) durch Einheiten der Formel

$$R_3SiO_{1/2} ,$$

wobei R die oben dafür angegebene Bedeutung hat, endblockiertes Organopolysiloxan mit 0,05 bis 5 Molprozent Einheiten der Formel

$$HSR^3R_aSiO_{\frac{3-a}{2}} ,$$

worin R, $R^3$ und a jeweils die oben dafür angegebene Bedeutung haben, während die restlichen Siloxaneinheiten, abgesehen von den Triorganosiloxygruppen, zu mindestens 99 Molprozent aus Einheiten der Formel

$$R_2SiO,$$

worin R die oben dafür angegebene Bedeutung hat, bestehen, und wobei Bestandteil (B) eine durchschnittliche Viskosität von 50 bis 2000 mPa.s bei 25°C hat, und

(C) Photosensibilisator

enthalten, wobei Si-gebundene Hydroxylgruppen, die sich in Einheiten der Formel

$$R_2SiO$$

befinden, höchstens in Mengen von 0,2 Hydroxylgruppen je Gruppierung der Formel

$$HR^1C{=}CR^2COOR^3-$$

vorliegen

und in diesen Massen insgesamt höchstens 0,02 Gewichtsprozent, bezogen auf das Gesamtgewicht der Bestandteile (A), (B) und (C) organische Titan- oder organische Zinnverbindungen vorliegen.

2. Massen nach Anspruch 1, dadurch gekennzeichnet, daß Bestandteil (B) 0,5 bis 1 Molprozent Einheiten der Formel

$$HSR^3R_aSiO_{\frac{3-a}{2}} ,$$

worin R, $R^3$ und a jeweils die in Anspruch 1 dafür angegebene Bedeutung haben, enthält.

3. Massen nach Anspruch 1 oder 2, dadurch gekennzeichnet, daß Bestandteil (A) eine Viskosität von 100 bis 2000 mPa.s bei 25°C hat.

4. Massen nach mindestens einem der Ansprüche 1 bis 3, dadurch gekennzeichnet, daß Bestandteil (B) eine Viskosität von 100 bis 1000 mPa.s bei 25°C hat.

5. Massen nach mindestens einem der Ansprüche 1 bis 4, dadurch gekennzeichnet, daß 0,5 bis 10 Einheiten der Formel

$$HSR^3R_aSiO_{\frac{3-a}{2}}$$

je Einheit der Formel

$$HR^1C{=}CR^2COOR^3SiR_2O_{1/2}$$

vorliegen.

6. Verfahren zum Einbetten von elektronischen Bauteilen, dadurch gekennzeichnet, daß Massen nach Anspruch 1, nachdem in ihnen elektronische Bauteile eingebettet wurden, durch Ultraviolett-Licht vernetzt werden.

7. Verfahren nach Anspruch 6, dadurch gekennzeichnet, daß Massen nach Anspruch 2, nachdem in ihnen elektronische Bauteile eingebettet wurden, durch Ultraviolett-Licht vernetzt werden.

8. Verfahren nach Anspruch 6 oder 7, dadurch gekennzeichnet, daß Massen nach Anspruch 5, nachdem in ihnen elektronische Bauteile eingebettet wurden, durch Ultraviolett-Licht vernetzt werden.